# NEUE EUROPÄISCHE PATENTSCHRIFT

(11) **EP 1 371 092 B2**
(45) Veröffentlichungstag und Bekanntmachung des Hinweises auf die Entscheidung über den Einspruch: **03.11.2010**
(45) Hinweis auf die Patenterteilung: 08.06.2005
(21) Anmeldenummer: 02727409.1
(22) Anmeldetag: 13.03.2002
(51) Int. Cl.: H01L 21/48, C03B 29/00, C03C 27/00, C03B 19/02, C03C 14/00

(54) **VERFAHREN ZUR STRUKTURIERUNG EINES AUS GLASARTIGEN MATERIAL BESTEHENDEN FLÄCHENSUBSTRATS**
METHOD FOR STRUCTURING A FLAT SUBSTRATE CONSISTING OF A GLASS-TYPE MATERIAL
PROCEDE DE STRUCTURATION D'UN SUBSTRAT PLAT EN UN MATERIAU VITREUX

(30) Priorität: 14.03.2001 DE 10112612; 14.04.2001 DE 10118529
(43) Veröffentlichungstag der Anmeldung: 17.12.2003
(73) Patentinhaber: Fraunhofer-Gesellschaft zur Förderung der angewandten Forschung e.V., 80686 München (DE)
(72) Erfinder: QUENZER, Hans-Joachim, 25524 Itzehoe (DE); SCHULZ, Arne, Veit, 22457 Hamburg (DE); WAGNER, Bernd, 25582 Looft (DE); MERZ, Peter, 25557 Hanerau-Hademarschen (DE)
(74) Vertreter: Rösler, Uwe
(86) Internationale Anmeldenummer: PCT/EP2002/002796
(87) Internationale Veröffentlichungsnummer: WO 2002/073684

(56) Entgegenhaltungen:
- WO-A-99/01893
- GB-A- 2 241 233
- US-A- 4 597 027
- US-A- 4 609 966
- US-A- 4 609 968
- US-A- 4 612 029
- US-A- 4 875 134
- US-A- 5 264 722
- US-A- 6 030 829
- 'Vaisala Technologies', Artikel 'Barocap Drucksensor Betriebsanleitung (D4A-D4K)'
- 'BAROCAP "meeting customer needs"' VAISALA NEWS Bd. 133, 1994,
- 'PTh 100 series analog barometers' VAISALA NEWS Bd. 133, 1994,
- 'Silicon BAROCAP Hits the Ten-Year Mark' VAISALA NEWS Bd. 137, 1995,
- 'QUALITY FIRST-Adjustment and Calibration of Vaisala's Digital' VAISALA NEWS Bd. 137, 1995,
- 'PTh 220 - A New Family of Digital Barometers' VAISALA NEWS Bd. 137, 1995,
- 'Vaisala Technologies Inc.', Artikel '15854SC Lead frame wired acceler'
- 'Capacitive Bulk', Artikel H KUISMA: 'Micromachined Sensors for High Volume Automotive Applications'
- 'VTI HAMLIN Oy', Artikel 'Angular rate sensor process documentation- Operation instructions, Glazing auf Finnisch'
- 'VTI HAMLIN Oy', Artikel 'Angular rate sensor process documentation- Operation instructions(Grinding auf Finnisch)'
- 'Transducers '97', 1997 Artikel KUISMA ET AL.: 'A Bulk Micromachined Silicon Angular Rate Sensor'

## Beschreibung

### Technisches Gebiet

Die Erfindung bezieht sich auf ein Verfahren zur Strukturierung eines aus glasartigem Material bestehenden Flächensubstrats.

### Stand der Technik

Glas oder glasartige Materialien als Werkstoff in der modernen Mikroelektronik oder Mikromechanik besitzen gegenüber anderen Materialien insbesondere Kunststoffe zahlreiche Vorteile hinsichtlich ihres mit Halbleitermaterialien vergleichbaren, geringen thermischen Ausdehnungskoeffizienten und verfügen darüber hinaus über eine große mechanische sowie auch chemische Stabilität, wodurch diese Materialien in vielen technischen Bereichen von großer Bedeutung sind.

Jedoch sind der Herstellung insbesondere von technisch sehr interessanten Produkten, insbesondere von mikromechanischen und mikroelektronischen Bauelementen aus Glas sehr enge Grenzen gesetzt, da bislang hinsichtlich der Mikrostrukturierung von Glas nur wenig geeigneten Ätzverfahren vorhanden sind, so daß bislang lediglich mechanischen Verfahren wie Sägen, Schleifen, Polieren, Ritzen, Ultraschall oder Sandstrahlen zum Einsatz kommen. Dadurch sind die Strukturierungsmöglichkeiten von Glas stark eingeschränkt. Mit diesen konventionellen Bearbeitungstechniken ist jedoch eine Strukturierung von Glas in den Mikro- und insbesondere Submikrometerbereich nicht mit der in der Halbleiter-Bauelement-Technik geforderten Präzision möglich.

Aufgrund dieser stark eingeschränkten Strukturierungsmöglichkeiten werden Mikrostrukturkörper bei allen z. Zt. bekannten Verfahren aus Kunststoff gefertigt. So beschreibt bspw. die DE 43 07 869 A1 ein Verfahren, bei dem Mikrostrukturkörper aus Kunststoff oder Sinterwerkstoffen mittels eines Formeinsatzes abgeformt werden. Der mikrostrukturierte Formeinsatz wird hierbei aus einem festen Körper, der aus Metall, Keramik, Glas, Stein oder einkristallinem Material ist, durch feinmechanische Präzisionsbearbeitung, additive oder subtraktive Strukturierung hergestellt. Anschließend wird der Formeinsatz mit fließfähigem Material ausgefüllt, überdeckt und nach seiner Verfestigung wird das Material von dem Formeinsatz getrennt. Der so gefertigte Mikrostrukturkörper weißt allerdings ebenfalls den Nachteil auf, dass er aus einem Material mit einem großen thermischen Ausdehnungskoeffizienten gefertigt ist und im Vergleich zu glasartigen Materialien über eine geringere mechanische und chemische Stabilität verfügt.

In der WO 97/19027 A1 wird ein Grundsubstrat sowie ein Verfahren zu seiner Herstellung erläutert, das eine Grabenstruktur aufweist, in die biologisches Probenmaterial eingebracht wird. Zur Strukturierung des Grundsubstrats wird dieses derart erwärmt, dass es sich leicht verformen lässt und bei Erreichen der erforderlichen Temperatur eine Stempeleinheit, die aus einem nicht deformierbaren Werkstoff besteht, auf das Grundsubstrat aufgebracht. Anschließend wird das Grundsubstrat abgekühlt und die Stempeleinheit wieder entfernt. Mit dem hier beschriebenen Verfahren können zwar auch Grundsubstrate aus glasartigen Werkstoffen verformt werden, die Kombination von beliebigen Bereichen aus Glas und Silizium auf ein und demselben Träger, je nach dem, welche Eigenschaften lokal erforderlich sind, ist aber auch mit diesem Verfahren nicht zu erreichen.

Könnten die technischen Grenzen in der Glasbearbeitung durchbrochen werden, so ließen sich neue Anwendungsgebiete erschließen, in denen Verbundwerkstoffe aus Silizium und Glas eine tragende Rolle spielen. Derartige Verbundelemente können sich die komplementären Eigenschaften beider Materialien zunutze machen. Zum Beispiel besitzt Glas im Vergleich zu Silizium eine sehr niedrige elektrische und thermische Leitfähigkeit, ist jedoch im Gegensatz zu Silizium im sichtbaren Wellenlängenbereich optisch transparent.

Zudem spielt neben Silizium Glas oder glasartige Materialien eine wichtige Rolle bei der Realisierung mikromechanischer Komponenten. Besonders im Hinblick auf eine Verkapseln der Bauelemente auf Waferlevel wird Glas als elektrisch isolierendes Material häufig eingesetzt. Aber auch in diesem Zusammenhang stößt man in der Mikrostrukturierung auf die vorstehend genannten Grenzen.

Mit den bisher bekannten Verfahren ist es nicht möglich ein inniges Gefüge aus einem Halbleiter, bspw. Silizium und Glas herzustellen, dessen Geometrie lateral im Mikro- und sub-Mikrobereich frei dimensioniert werden kann. Dies jedoch wäre wünschenswert, sodass auf ein und demselben Träger beliebige Bereiche aus Glas und Silizium miteinander kombiniert und vor allem dimensioniert werden können, je nach dem welche Eigenschaften lokal erforderlich sind.

Aus der WO 99/01893 geht Verfahren zur Herstellung schichtartiger Gebilde hervor, die vorzugsweise Schichten aus Halbleitermaterialien enthalten und besonders vorzugsweise als Silizium-Solar-Zellen dienen. Bei der Schichtherstellung bedient man sich der Abscheidung einer porösen Zwischenschicht auf ein vorstrukturiertes Substrat, auf die einkristallines Silizium aufgebracht wird, die Zwischenschicht dient in erster Linie als Haftvermittler, um möglichst spannungsfrei monokristallines Silizium auf ein Substrat aufzuwachsen.

Der GB 2 2451 233 ist ein Verfahren zur Herstellung von perforierten Glas zu entnehmen, bei dem erweichtes Glas in eine die Perforationsform vorgebende Maske hineinfliest, erkaltet und anschließend von der Maske getrennt wird. Als Endprodukt wird eine flächige perforierte Glasscheibe erhalten.

### Darstellung der Erfindung

Der Erfindung liegt die Aufgabe zugrunde ein Verfahren zur Strukturierung eines aus glasartigem Material bestehenden Flächensubstrats derart anzugeben, dass eine Strukturierung von Glas oder glasartigen Materialien, vorzugsweise in Form eines Flächensubstrats mit Strukturdimensionen im Mikro- und sub-Mikrobereich nahezu beliebig vorgenommen werden soll. Insbesondere soll der Werkstoff Glas in der Mikroelektronik sowie auch Mikromechanik in Hinblick auf Verarbeitungsfähigkeit und Einsatzspektrum eine mit Halbleitermaterialien vergleichbare Bedeutung erreichen. Das Verfahren soll eine präzise und möglichst kostengünstige Herstellung derartig strukturierter glasartiger Flächensubstrate sowie auch gestatten. Auch soll das Verfahren grundsätzlich die Möglichkeit bieten Halbleitersubstrate und glasartige Flächenmaterialien miteinander in einen innigen Kontakt zu bringen und in Verbundform miteinander in gewünschter Weise zu strukturieren.

Die Lösung der der Erfindung zugrundeliegenden Aufgabe ist im Anspruch 1 angegeben. Gegenstand des Anspruchs 19 ist ein mit diesem Verfahren hergestelltes und strukturiertes glasartiges Flächensubstrats. Ferner werden bevorzugte Verwendungen der mit dem Verfahren herstellbaren Produkte angegeben. Gegenstand der Unteransprüche sowie der Beschreibung insbesondere unter Bezugnahme auf die Figuren betreffen den Erfindungsgedanken vorteilhaft weiterbildende Merkmale.

Das erfindungsgemäße Verfahren macht sich die in der Halbleiterbearbeitung üblichen Formgebungsverfahren zunutze. So sind Formgebungsverfahren insbesondere für einkristallines Silizium in der Halbleitertechnologie weit verbreitet und gehören zu den Standardverfahren. Durch die Kombination von Lithographieprozessen mit nasschemischen isotropen sowie auch anisotropen Ätzverfahren und diversen Trockenätzverfahren stehen eine große Anzahl an Möglichkeiten zur Herstellung von fast beliebig strukturierten Siliziumoberflächen zur Verfügung. Durch die Massenanwendung in der Halbleitertechnik sind diese Verfahren kostengünstig verfügbar.

Um die in der Halbleitertechnologie erfolgreich angewandten Strukturierungsverfahren auch an Glas oder glasartigen Materialien anwenden zu können dient das nachstehende erfindungsgemäße Verfahren, das sich im einzelnen aus den folgenden Verfahrensschritten zusammensetzt:

Zunächst wird ein aus einem Halbleitermaterial bestehendes Halbleiter-Flächensubstrat, bspw. in Form eines Silizium-Wafers bereitgestellt, das mit den bekannten Techniken in einem nachfolgenden Schritt strukturiert wird.
So werden mit herkömmlichen Lithographieprozessen digitale oder kontinuierliche Strukturen in einen photosensitiven Lack übertragen, der bspw. auf ein Siliziumsubstrat, vorzugsweise einkristalliner Siliziumwafer, aufgebracht ist. Mit der in der Halbleiterindustrie üblichen Kontakt- oder Projektionsbelichtung stehen Standardverfahren zur Übertragung von digitalen Strukturen zur Verfügung. Mit Hilfe der Grautonlithographie können somit auch fast beliebig geformte Oberflächen abgebildet werden. Nach dem Belichten wird in einem Entwicklerbad das nicht belichtete Lackvolumen entfernt. Durch Ätzprozesse wird die Topographie des Lackes in das Silizium übertragen. In Frage kommen dabei sowohl nasschemische Ätzverfahren (KOH-Verfahren) als auch im besonderen Maße Plasmaätzverfahren (Plasma-Etch, Reactive lon Etch (RIE)). Mit beiden Verfahren können auch vergleichsweise tiefe Strukturen mit Strukturdimensionen im Submikrometerbereich hergestellt werden.

Nun erfolgt ein inniges Verbinden der Oberfläche des Halbleiter-Flächensubstrats mit einem glasartigen Flächensubstrat, unter Unterdruck bedingungen wobei die strukturierte Oberfläche des Halbleiter-Flächensubstrats mit einer Oberfläche des glasartigen Flächensubstrats mindestens teilweise überdeckend zusammengeführt wird. Zur festen und innigen Verbindung beider Flächensubstrate eignet sich besonders das anodische Bonden, sodass eine hermetisch dichte Verbindung zwischen beiden Flächensubstraten entsteht und der Unterdruck zwischen dem Halbleiter Flächensubstrat und dem glasartigen Flächensubstrat konserviert wird.

Die Technik des Anodischen Bondens ist bereits seit Ende der sechziger Jahre bekannt, bei der zwei hochplanare Substrate, in der Regel bestehend aus einem Metall- und einem Isolatorsubstrat auf einer sogenannten "Hot Plate" erhitzt. Im vorstehend beschriebenen Fall werden das Halbleiter- und das glasartige Flächensubstrat zusammengefügt. Zusätzlich wird eine Spannung zwischen beiden Flächensubstraten von bis zu 1000 V angelegt. Befindet sich der negative Pol am glasartigen Flächensubstrat, so wandern die in der Glasmatrix vorhandenen positiven, beweglichen lonen in Richtung Kathode. Die unbeweglichen, und somit ortsfesten Sauerstoffionen bilden an der Grenze zum Halbleiter eine negative Raumladungszone. Zum einen führt die resultierende elektrostatische Kraft zu einem engen Kontakt der beiden Substratoberflächen. Zum anderen wird durch die starken elektrischen Felder an der Grenzfläche zwischen dem Halbleiter-Flächensubstrat, bspw. ein Siliziumwafer, und dem Glas eine elektrochemische Reaktion ausgelöst in deren Verlauf sich an der Grenzfläche ein Oxid ausbildet das beide Substrate miteinander verbindet.

Beim Anodischen Bonden von Si und Glas wird als glasartiges Flächensubstrat ein Borosilikatglas (Pyrex™, Borofloat™) verwendet, das im thermischen Ausdehnungskoeffizient weitgehend an Silizium angepaßt ist. Allerdings werden bei diesem Verfahren die beiden scheibenförmig vorliegenden Materialien als vertikaler Verbund (einfach oder mehrfach) übereinandergestapelt.

Nun erfolgt der eigentliche Struktur-übertragende Schritt vom vorstrukturierten Halbleiter-Flächensubstrat auf das glasartige Flächensubstrat, im Wege eines Tempervorganges der verbundenen Flächensubstrate. Im Wege eines Ofenprozess, bei dem das glasartige Material in den plastischen Bereich oberhalb der Glastemperatur T_{G} erhitzt wird, füllt das Glasmaterial die Strukturöffnungen bzw. die Vertiefungen innerhalb des Halbleiter-Flächensubstrats vollständig aus. Nach entsprechendem Abkühlen beider innig miteinander verbundenen Flächensubstrate, deren thermisches Ausdehnungsverhalten vergleichbar oder gar identisch sind, wodurch nur geringe oder keine thermischen Spannungen auftreten, weist das glasartige Flächensubstrat die Struktur des Halbleiter-Flächensubstrats in der Negativform auf.

Anschließend wird die Oberfläche des glasartigen Flächensubstrats bis auf die vorstrukturierte Halbleiteroberfläche zurückgeschliffen und poliert, z.B. durch Chemisch-mechanisches Polieren, sodass bereits nach Vollendung dieses Bearbeitungsschrittes ein Verbund-Flächensubstrat erhalten wird, in dem Glas oder glasartiges Material mit Strukturdimensionen geformt ist, die bislang nur Halbleitermaterialien und allen voran einkristallines Silizium vorbehalten waren.

In weiteren vorteilhaften Bearbeitungsschritten wird nun die Rückseite des Halbleiter-Flächensubstrat bearbeitet, indem das überschüssige Halbleitermaterial, bspw. Silizium ebenfalls durch Schleifen und Polieren entfernt wird. Damit bleibt ein Substrat übrig, das in bestimmten Arealen aus Halbleitermaterial und in anderen aus dem glasartigen Material besteht.

Zusätzlich ist es möglich in einem weiteren Ätzprozess das Halbleitermaterial zu entfernen, um zum Beispiel sehr schmale Löcher oder Durchbrüche im Glassubstrat zu erhalten. Weitere mechanische Schleif- und Poliervorgänge können sich daran anschließen, um die Durchbrüche präzise zu öffnen bzw. entsprechende Öffnungskonturen zu erhalten.

Unter Ausnutzung der Fliesseigenschaft von Glas im erhitzten Zustand kann also die Oberflächentopographie von einem strukturierten Halbleiter-Flächensubstrats, bspw. in Form eines Siliziummasters, in glasartige Materialien exakt übertragen werden. Dadurch ergeben sich erhebliche Vorteile in der Fertigung und in Bezug auf die Präzision. So können die Vorteile der Siliziumtechnologie (exakte Formgebungsverfahren bis in den sub-µm-Bereich hinein, Vielfalt der Strukturierungsmöglichkeiten) sowie die guten Materialeigenschaften von Glas kombiniert werden.

Bei hinreichend großen Strukturhöhen im ursprünglichen Halbleiter-Flächensubstrats und kompletter Abformung in das glasartige Flächensubstrat durch einen geeigneten Glasfliessprozess, können damit Flächen erzeugt werden, die komplett durch das neue Verbundsubstrat hindurch reichen. Je nach der flächenmäßigen Verteilung können auf diese Weise Glaswafer mit Siliziumdurchführungen oder Siliziumwafer mit Glasfenster erzeugt werden.

Ein besonders wichtiger Aspekt hierbe ist die sehr gute thermische Verträglichkeit beider Materialien, bspw. Silizium und Glas (Borosilikatgläser wie etwa Pyrex®, Tempax® oder Borofloat Glas). Aufgrund der fast perfekten Übereinstimmung der thermischen Ausdehnungskoeffizienten zwischen Silizium und Pyrexglas® läßt sich gewissermaßen ein thermisch homogenes Substrat herstellen. Insbesondere treten dadurch keinerlei Effekte auf, die auf thermisch induzierten Streß zurückzuführen sind, wie etwa Neigung zu Rißbildung oder Verbiegung der Substrate.

Die Dicke beider Flächensubstrate liegt typischerweise zwischen 0.1 mm und 1 mm. Es wird an dieser Stelle betont werden, daß die laterale Geometrie der Segmentierung des Halbleiter- und glasartigen Flächensubstrats keiner prinzipiellen Einschränkung unterworfen ist. Die Bereiche unterschiedlicher Materialien können zusammenhängend oder nicht zusammenhängend sein. Die minimalen Abmessungen der Bereiche hängen von der Präzision des primären Halbleiter-Strukturierungsverfahrens und der mechanischen Stabilität des Wafers oder Chips ab. Mit anisotropem Trockenätzen ("Deep RIE") wird man bei den Siliziumstrukturen etwa ein Aspektverhältnis (Höhe:Breite) von 10:1 erreichen können. Damit entstünden beispielsweise in einem 500 µm dicken Glaswafer Durchbrüche oder Löcher mit 50 µm Durchmesser. Die feinsten Glasstrukturen können allerdings geringere Abmessungen haben, da es möglich ist in Silizium sehr feine Löcher zu ätzen, bspw. mittels Porenätzen.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1: Ablaufschema des erfindungsgemäßen Verfahrens zur Herstellung eines strukturierten glasartigen Flächensubstrates,
- Fig. 2: Draufsicht auf ein glasartiges Flächensubstrat mit elektrischen Durchführungen,
- Fig. 3a,b: Anwendungsbeispiele für ein prozessiertes glasartiges Flächensubstrat sowie
- Fig. 4: Draufsicht auf ein Halbleiter-Flächensubstrat mit isolierten elektrischen Durchführungen.

### Wege zur Ausführung der Erfindung, gewerbliche Verwendbarkeit

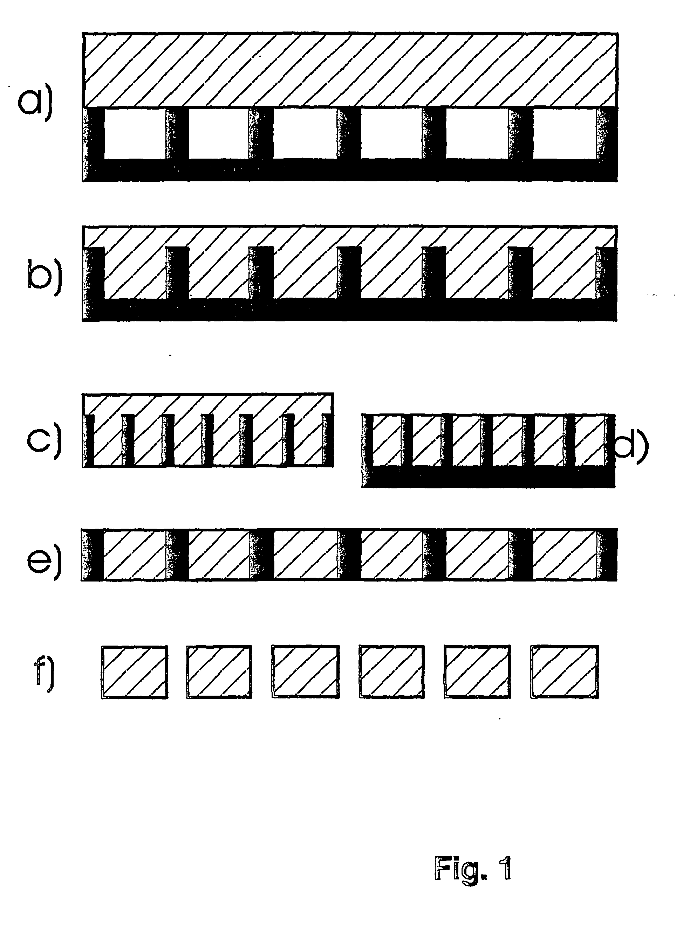

In Fig. 1 sind die erfindungsgemäßen Verfahrensschritte in schematisierter Abfolge dargestellt. Die in den Fig. 1a bis 1f gezeigten Abbildungen weisen schraffierte Flächenbereiche auf, die dem glasartigen Flächensubstrat, beispielsweise einem einkristallinen Siliziumwafer entsprechen. Die schwarz ausgeführten Flächenbereiche betreffen das Halbleiter-Flächensubstrat, das in einer vorgegebenen Weise strukturiert ist.

In Fig. 1a wird das glasartige Flächensubstrat auf das bereits vorstrukturierte Halbleiter-Flächensubstrat im Wege des anodischen Bondens innig verfügt. Hierbei schließen beide Flächensubstrate Zwischenvolumen ein, die durch die Geometrie der Vertiefungen innerhalb der Oberfläche des Halbleiter-Flächensubstrates vorgegeben sind. Das Zusammenfügen beider Flächensubstrate erfolgt unter Vakuumbedingungen, so dass sich nach erfolgtem anodischen Bonden gemäß Fig. 1a in einem darauffolgenden Tempervorgang (Fig. 1b) das über die Glastemperatur erhitzte glasartige Flächensubstrat vollständig in die Strukturöffnungen des vorstrukturierten Halbleiter-Flächensubstrates verteilt. Der Tempervorgang, der vorzugsweise in einem Ofenprozess erfolgt, wird unter Normaldruckbedingungen oder unter erhöhten Druckbedingungen durchgeführt. Die treibende Kraft, mit der das plastische Glasmaterial in die Strukturöffnungen hineingetrieben wird, ist zwar grundsätzlich das innerhalb der Strukturöffnungen eingeschlossene Vakuum, doch kann der Vorgang durch etwaig vorhandene Überdruckbedingungen innerhalb des Temperofens unterstützt werden. Bei konstanter Temperatur und entsprechender Prozesszeit haben jedoch die Materialeigenschaften des glasartigen Flächensubstrates den entscheidenden Einfluss auf die Ausprägung und Genauigkeit der Strukturabformung.

Nach entsprechendem Erkalten beider nun innig miteinander verzahnten Flächensubstrate erfolgt ein Materialabtrag mittels geeigneter Schleif- und/oder Polierprozessen. Je nach späterer Verwendungsweise kann gemäß Fig. 1c das Halbleiter-Flächensubstrat von unten abgetragen werden, so dass ein glasartiges Flächensubstrat entsteht, in dem feinst strukturierte Halbleiterbereiche enthalten sind oder aber es wird gemäß Verfahrensschritt Fig. 1d das glasartige Flächensubstrat von oben in der Weise abgetragen, so dass das glasartige Flächensubstrat bündig mit der strukturierten Oberfläche des Halbleiter-Flächensubstrates abschließt (siehe hierzu Fig. 1d).

Fig. 1e zeigt schließlich das Ergebnis eines weiteren Materialabtrageprozesses, der die über die strukturierten Bereiche hinausstehenden, entsprechenden Flächensubstratanteile (siehe hierzu Fig. 1c, 1d) beseitigt. In diesem Stadium wird ein feinst strukturiertes glasartiges Flächensubstrat erhalten, das mit einer Vielzahl von Halbleiter-Durchbrüchen vollständig durchsetzt ist. Eine derartige Verbundkomponente kann, wie nachstehend erläutert wird, zur selektiven elektrischen Kontaktierung von mikroelektronischen Bauelementen dienen.

In Fig. 1f ist ein mit Perforierungen bzw. vollständigen Durchbrüchen versehenes glasartiges Flächensubstrat dargestellt, das nach Durchführung eines Ätzprozesses, in dem die in Fig. 1 dargestellten Halbleiter-Materialbereiche entfernt werden, erhalten wird.

Alternativ zur vollständigen Beseitigung des strukturierten Halbleiter-Flächensubstrates im Wege des in Fig. 1f angedeuteten Ätzprozesses ist es auch möglich, beide Flächensubstrate beispielsweise nach vollendeter Abkühlung im Anschluss an den Tempervorgang voneinander zu trennen, indem eine geeignete Trennschicht zwischen beiden Flächensubstraten eingebracht wird. So ist es insbesondere möglich, dass durch Aufbringen geeigneter Trennschichten eine Wiederverwendung des vorstrukturierten Halbleiter-Flächensubstrates realisierbar ist, wodurch die Verfahrenskosten erheblich reduziert werden können. Hierzu ist es erforderlich, dass vor dem Verbinden beider Flächensubstrate eine oder mehrere Trennschichten zwischen beiden Flächensubstraten eingebracht werden. Prinzipiell gibt es hierzu mehrere Möglichkeiten:
a) Auf dem Halbleiter-Flächensubstrat, bspw. Si-Wafer, wird eine Kohlenstoffschicht (auch Diamant oder Diamantähnliche, SiC) aufgebracht, die ein Ankleben des Glases am Silizium unterbindet. Die Verbindung des Si-Wafers mit dem Glaswafer wird durch einen Ring aus einem Lot erreicht, der die beiden Wafer am Waferrand vakuumdicht verbindet. Zwar wird das Lot bei der Prozesstemperatur bei der das Glasfließen stattfindet flüssig, die schlechte Benetzung der unbeschichteten Glas bzw. Kohlenstoffschichten verhindert jedoch, daß das Lot zu weit zwischen die Wafer eindringen kann. Die Trennung der beiden Wafer kann entweder rein mechanisch erfolgen, der Lotring kann auch durch Ätzen entfernt werden oder aber die Kohlenstoffschicht wird durch einen Oxidationsprozess (ca. 400 - 500°C unter Sauerstoff) zwischen den beiden Substraten abgetragen. Vor einen weiteren Einsatz des Siliziumwafers müssen diese Schichten unter Umständen diese Trennschicht erneut aufgetragen werden.
b) Auf dem Si-Wafer wird eine Haftvermittlungsschicht aus einem geeigneten Metall aufgebracht z.B. Tantal. Auf dieser Schicht wird ein weiteres Metall aufgebracht, z.B. Zinn. Zinn verhindert ebenfalls ein Ankleben des Glases am Silizium und ist während des Glasfließprozesses flüssig Die Trennung der beiden Wafer kann entweder während eines weiteren Temperschritt oberhalb des Schmelzpunkts von Zinn rein mechanisch erfolgen oder aber das Metall wird selektiv zum Silizium und Glas herausgeätzt.
c) Auf dem Siliziumwafer wird eine zweite Schicht aufgebracht, mit der direkt der Glaswafer verbunden werden kann (z.B. durch anodic bonding). Beispiele hierfür wären Silizium, Titan, Aluminium oder Tantal. Am Ende des gesamten Prozesses wird diese Opferschicht durch Ätzen selektiv zum Glas oder Silizium entfernt. Um zu vermeiden, dass der ursprüngliche Si-Wafer angegriffen wird, kann der Wafer auch mit geeigneten Schichten versehen werden, z.B. Siliziumnitrid oder Siliziumcarbid.

Mit den geeigneten Trennschichten kann der Herstellungsprozess so abgewandelt werden, daß der Siliziumwafer mehrfach eingesetzt werden kann. Unter Umständen müssen die Trennschichten vor einem erneuten Einsatz wieder aufgebracht werden. Der nach dem Abtrennen des Siliziumwafers erhaltene strukturierte Glaswafer muß schließlich nur noch auf der Rückseite abgeschliffen werden, um komplette Durchbrüche zu erhalten. Diese Durchbrüche können in einem weiteren Prozeß z.B. galvanisch mit Metallen aufgefüllt werden

Im Allgemeinen erfolgt in der Mikroelektronik und Mikrosystemtechnik die elektrische Kontaktierung von Chips über am Rand der Chips liegende Pads. In einer Reihe von Anwendungsfällen ist dies jedoch nachteilhaft und daher nicht gewünscht. Beispielsweise
- aus elektrischen Gründen, um Signalverluste zu reduzieren, z.B. bei kleinen kapazitiven Signalen oder bei HF-Signalen. Die elektrische Durchführung bietet einen geringeren Serienwiderstand, geringere Streukapazitäten und geringere Induktivitäten als die Kontaktierung über den Rand.
- aus Platzgründen. Dies gilt insbesondere für Systeme, die nahtlos arrayförmig aus mehreren Chips zusammengesetzt werden müssen, z.B. großflächige Detektorenarrays oder Mikrospiegelarrays. In diesen Fällen muß bei den inneren Chips auf den Padbereich verzichtet werden. Aber auch bei Einzelbauelementen gibt es oftmals Platzprobleme, z.B. bei medizinischen Mikrosonden (Elektroden zur Stimulation oder Registrierung).
- wenn mehrere funktionale Chips übereinandergestapelt werden und einen Stack bilden. Beispielsweise kann die oberste Ebene aus Sensoren (z.B. optische) bestehen und in dem Chip darunter die Signalverarbeitungselektronik liegen.
- Probe-Cards bestehen aus Mikrokontaktarrays zum automatisierten elektrischen Test von Chips, Wafern oder Leiterplatten. In diesem Fall ist aus elektrischen Gründen, bei größeren Probe-Cards auch aus Platzgründen eine Durchkontaktierung gewünscht.

In eben jenen Fällen ist eine Durchkontaktierung durch den Chip eine Alternative, die mit einem erfindungsgemäß prozessierten Glassubstrat möglich ist.

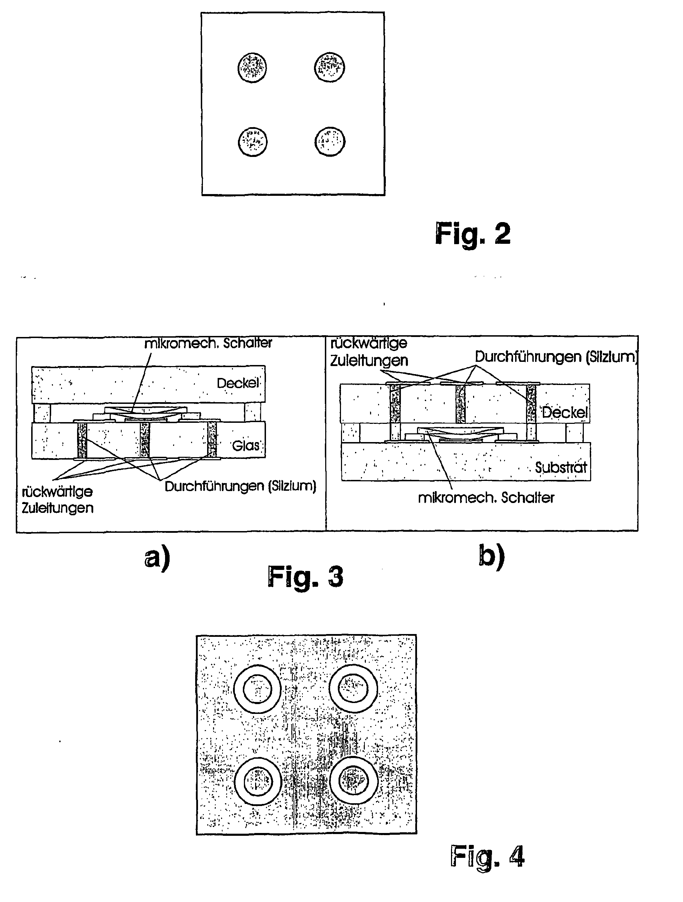

Figur 2 zeigt eine schematisierte Draufsicht auf einen prozessierten Glaswafer (weißer Bereich), der mit elektrischen Kontakten (schwarze Bereiche) durchsetzt ist. Eine derartige Struktur ist im Verfahrensschritt gemäß der Figur 1e erhältlich. Die elektrischen Kontakte durch den Glaswafer können aus hochfliegendem Silizium (Verfahren ohne Trennschicht) oder aus Metallen bestehen (Verfahren mit Trennschicht und nachfolgendem Aufmetallisieren der freien Durchbrüche innerhalb des Glaswafers).

Besonders vorteilhaft erscheint die Verwendung derartig strukturierter Substrate für den Aufbau mikromechanischer Komponenten für den Hochfrequenzbereich 1- 100 GHz. Ein konkretes Beispiel hierzu ist der Figur 3 a) und b) zu entnehmen. In diesem Beispiel wird auf einem Glassubstrates mit elektrischen Durchführungen ein mikromechanisches Bauelement (mirkomechanischer Schalter) aufgebaut (Fig. 3a). Am Ende des gesamten Herstellungsablaufs wird die gesamte Struktur hermetisch mit einem Deckelwafer im Wege eines Lötprozesses verkappt, wobei auch die elektrischen Kontakte zwischen beiden Wafern hergestellt werden. Alternativ können die elektrischen Kontakte auch in den Deckel eingebracht werden (Fig. 3b).

Auch dienen die in Figur 2 dargestellten elektrischen Kontaktbereiche der gezielten Wärmeabführung. Einsatzbereiche sind denkbar bei Anwendungen, bei denen in einem Glassubstrat in bestimmten Bereichen Wärme abgeführt werden muß. Die Silizium- oder Metalldurchführungen dienen hier also als Wärmeleitpfade.

In Figur 4 ist ein Ausführungsbeispiel für ein Siliziumwafer (schwarze Bereiche) dargestellt, der zu Zwecken isolierter elektrischer Durchführungen ringförmige Glasbereiche (weiße Bereiche) aufweist. Eine derartige Struktur kann auch in etwas abgewandelter Form im Rahmen des Verfahrensschrittes gemäß Figur 1 e erhalten werden. Derartige Siliziumwafer, bei denen in bestimmten Bereichen aus elektrischen, thermischen oder optischen Gründen Glas eingearbeitet sind, eignen sich für eine Vielzahl unterschiedlicher Anwendungsfälle:
- Siliziumwafer mit thermisch isolierten Bereichen
   Für diese Anwendungen sind die Strukturen nach den Figuren 1d oder 1e geeignet. Thermisch isolierte Bereiche auf Siliziumwafern sind insbesondere bei thermischen Sensoren erforderlich, zum Beispiel bei Thermopiles, Bolometern oder pyroelektrischen Sensoren. Für diese Sensortypen werden bislang Membranstrukturen im oder auf dem Chip erzeugt, um die thermische Isolation zu gewährleisten. Diese Sensoren sind jedoch aus Stabilitätsgründen nicht für Einsatzbereiche mit hoher mechanischer Belastung geeignet.
- Siliziumwafer mit elektrisch isolierten Bereichen
   Hierzu sind ebenfalls die Strukturen gemäß der Figuren 1d oder 1e nutzbar. Auf den Glasbereichen können insbesondere passive HF-Bauelemente (z.B. Induktivitäten) oder MEMS-Bauelemente mit hoher Güte platziert werden. Auf reinen Siliziumsubstraten können aufgrund der Verluste im Substrat keine hohen Güten erreicht werden.
- Siliziumwafer mit optischen Fenstern
   Hierzu können die Strukturen gemäß der Figuren 1c oder 1e eingesetzt werden. Einsatzmöglichkeiten sind z.B. Lichtkollimatoren mit spezifischer Formgebung oder Kollimatorarrays mit engen Öffnungen.

Generell ist die Herstellung hermetisch dichter Verbindungen bereits auf Waferebene ein sehr wichtiges Thema in der Mikrosystemtechnik. Bewegliche Mikrostrukturen müssen in jedem Fall gegen widrige Umweltbedingungen geschützt werden, am besten noch auf Waferebene. Neben den Kostenaspekten die für eine Verkapselung auf Waferebene sprechen, spielt vor allem ein Schutz gegenüber den notwendigen Vereinzelungsprozessen eine sehr wichtige Rolle. Da zudem häufig eine hermetisch dichte Versiegelung erforderlich ist, ergibt sich zwangsläufig das Problem der elektrischen Durchführungen unterhalb der Versiegelungsflächen. In diesem Zusammenhang die Verkapselung von mikroelektronischen Bauelementen betreffend unterstützt das erfindungsgemäße Verfahren die CSP-Technologie (Chip Side Packaging).

Im Falle der Siliziumsensoren haben sich Verfahren auf der Basis von Glasloten bewährt, allerdings werden dabei Prozesstemperaturen von ca. 400°C benötigt, eindeutig zu hoch etwa für metallische Mikroelemente. Zudem eignen sich Verbindungstechniken auf der Basis von Glasloten nur zum Versiegeln über eine vergleichsweise niedrige Topographie (ca. 0.5µm).

Hermetisch dichte Verbindungen bei Temperaturen unterhalb 250 - 300°C lassen sich anderseits durch Löten herstellen. Hier ergibt sich allerdings zwangsläufig das Problem, daß die Zuleitungen bei den zur Verfügung stehenden Isolationsmaterialien und deren prozesstechnisch herstellbaren Schichtdicken stark miteinander kapazitiv gekoppelt sind. Daher scheiden solche Durchführungen für die Herstellung von mikromechanischen Bauelementen für hohe Frequenzen eigentlich aus. Nur durch die Verwendung von Durchführungen durch das Substrat oder den Deckel hindurch ist eine ausreichende Trennung der Leitungen möglich.

Neben den bereits genannten Aspekten spricht für die Herstellung von Durchführungen auch die verbesserte Handhabung des kompletten Chips. Insbesondere eignen sich solcherart aufgebaute Bauelemente auch für die Nutzung innerhalb von Flip-chip Prozessen oder sogar der Verwendung des Chips direkt in der Leiterplattenbestückung z.B. als SMD Bauteil.

Abschließend sei darauf hingewiesen, dass das erfindungsgemäße Verfahren die Parallel-Herstellung von einer Vielzahl von einzelnen strukturierten glasartigen Flächensubstrate ermöglicht, die überdies im Rahmen eines Batch-Verfahrens produziert werden können, wodurch sich das Verfahren auch unter den Gesichtspunkten der industriellen Massenfertigung hervorragend eignet.

## Patentansprüche

1. Verfahren zur Strukturierung eines aus glasartigem Material bestehenden Flächensubstrats,
mittels der Kombination folgender Verfahrensschritte:
- Bereitstellen eines aus einem Halbleitermaterial bestehenden Halbleiter-Flächensubstrats,
- Strukturieren mindestens einer Oberfläche des Halbleiter-Flächensubstrats zum Erhalt von Vertiefungen auf der Oberfläche,
- Verbinden der Oberfläche des Halbleiter-Flächensubstrats mit dem glasartigen Flächensubstrat **durch** anodisches Bonden, wobei die strukturierte Oberfläche des Halbleiter-Flächensubstrats mit einer Oberfläche des glasartigen Flächensubstrats mindestens teilweise überdeckend zusammengeführt wird und während des Verbindungsprozesses Unterdruck vorherrscht, sodass dieser nach der Verbindung in den Vertiefungen der Oberfläche des Halbleiter-Flächensubstrats, zwischen dem Halbleiter-Flächensubstrat und dem glasartigem Flächensubstrat konserviert wird,
- Tempern der verbundenen Flächensubstrate derart, dass ein Hineinfließen wenigstens von Teilbereichen des glasartigen Materials in die Vertiefungen der strukturierten Oberfläche des Halbleiter-Flächensubstrats erfolgt,
- Materialabtrag zumindest des wiederverfestigten glasartigen Flächensubstrates, derart, dass das glasartige Flächensubstrat eine bündig zur strukturierten Oberfläche des Halbleiter-Flächensubstrats anschließende Oberfläche annimmt.

2. Verfahren nach Anspruch 1,
**dadurch gekennzeichnet, dass** an der Oberfläche des Halbleiter-Flächensubstrats, die der mit dem glasartigen Flächensubstrat verbundenen Oberfläche gegenüberliegt, Halbleitermaterial abgetragen wird, bis zumindest Teilbereiche des in die Vertiefungen hineingeflossenen glasartigen Materials freigelegt sind, die bündig mit der Oberfläche des Halbleiter-Flächensubstrats abschließen.

3. Verfahren nach Anspruch 1 oder 2,
**dadurch gekennzeichnet, dass** das Halbleiter-Flächensubstrat vom glasartigen Flächensubstrat abgetrennt wird.

4. Verfahren nach Anspruch 3,
**dadurch gekennzeichnet, dass** das Abtrennen des glasartigen Flächensubstrats vom Halbleiter-Flächensubstrat durch Wegätzen des Halbleitermaterials erfolgt.

5. Verfahren nach Anspruch 3,
**dadurch gekennzeichnet, dass** das Abtrennen beider Flächensubstrate voneinander durch Vorsehen einer Trennschicht zwischen beiden Flächensubstraten erfolgt.

6. Verfahren nach Anspruch 5,
**dadurch gekennzeichnet, dass** die Trennschicht vor dem Zusammenführen beider Flächensubstrate auf der strukturierten Oberfläche des Halbleiter-Flächensubstrats strukturerhaltend aufgebracht wird und als Opferschicht ausgebildet ist, die im Wege thermischer und/oder chemischer Einwirkung zerstört wird und ein Trennen beider Substrate voneinander ermöglicht.

7. Verfahren nach Anspruch 5 oder 6,
**dadurch gekennzeichnet, dass** als Trennschicht eine Metallschicht eingesetzt wird, die einen Schmelzpunkt aufweist, der unterhalb der Schmelzpunkte der Substrate liegt.

8. Verfahren nach Anspruch 5 oder 6,
**dadurch gekennzeichet, dass** als Trennschicht eine oxidationsfähige Schicht eingesetzt wird, die sich unter Zufuhr von Sauerstoff und/oder thermischer Energie chemisch umwandelt.

9. Verfahren nach Anspruch 5 oder 6,
**dadurch gekennzeichnet, dass** als Trennschicht eine Kohlenstoffschicht, Diamantschicht, diamantähnliche Schicht oder SiC eingesetzt wird.

10. Verfahren nach einem der Ansprüche 1 bis 9,
**dadurch gekennzeichnet, dass** das glasartige Material und das Halbleitermaterial über nahezu die gleichen thermischen Ausdehnungskoeffizienten verfügen.

11. Verfahren nach einem der Ansprüche 1 bis 10,
**dadurch gekennzeichnet, dass** das aus einem glasartigen Material bestehende Flächensubstrat ein Bor-Silikat-Glas ist.

12. Verfahren nach einem der Ansprüche 1 bis 11,
**dadurch gekennzeichnet, dass** das Halbleiter-Flächensubstrat ein Siliziumsubstrat ist.

13. Verfahren einem der Ansprüche 1 bis 12,
**dadurch gekennzeichnet, dass** während des Temperns ein Überdruck auf die vom Halbleiter-Flächensubstrat abgewandte Oberfläche des glasartigen Flächensubstrats einwirkt.

14. Verfahren nach einem der Ansprüche 1 bis 13,
**dadurch gekennzeichnet, dass** der Temperprozess durch Steuerung der Temperatur und der Dauer derart ausgeführt wird, dass das Hineinfließen des glasartigen Materials in die Vertiefungen des Halbleiter-Flächensubstrats beendet wird, wenn das glasartigen Material die Vertiefungen vollständig ausfüllt.

15. Verfahren nach einem der Ansprüche 3 bis 14,
**dadurch gekennzeichnet, dass** nach dem Abtrennen beider Flächensubstrate voneinander das glasartige Flächensubstrat mechanisch nachbearbeitet wird, zum Erhalt von das Flächensubstrat senkrecht durchsetzende Durchbrüche.

16. Verfahren nach Anspruch 15,
**dadurch gekennzeichnet, dass** die Durchbrüche mit einem elektrisch leitfähigem Material aufgefüllt werden.

17. Verfahren nach einem der Ansprüche 1 bis 15,
**dadurch gekennzeichnet, dass** das Strukturieren des Halbleiter-Flächensubstrats mittels Lithographietechnik und nachfolgender Ätztechnik erfolgt zur Erzeugung von Strukturen mit Strukturdimensionen im Mikro- und/oder sub-Mikrometer-Bereich.

18. Verfahren nach Anspruch 17,
**dadurch gekennzeichnet, dass** die Strukturen in Form von Vertiefungen ein Aspektverhältnis (Höhe bzw. Tiefe:Breite) von 10:1 aufweisen.

19. Glasartiges Flächensubstrat, hergestellt nach einem Verfahren nach den Ansprüchen 1 bis 18,
**dadurch gekennzeichnet, dass** das glasartige Flächensubstrat senkrecht zur Substratoberfläche von Durchbrüchen durchsetzt ist, in denen elektrisch leitfähiges Material vorgesehen ist.

20. Glasartiges Flächensubstrat nach Anspruch 19,
**dadurch gekennzeichnet, dass** die mit elektrisch leitfähigen Material gefüllten Durchbrüche arrayförmig angeordnet sind.

21. Verwendung des glasartigen Flächensubstrats nach Anspruch 19 oder 20 zur elektrischen Kontaktierung von Bauelementen aus der Mikroelektronik oder Mikromechanik.

22. Verfahren nach einem der Ansprüche 1 bis 18,
**dadurch gekennzeichet, dass** ein mit einem glasartigen Material durchsetztes Halbleiter-Flächensubstrat hergestellt wird.

23. Verfahren nach Anspruch 22,
**dadurch gekennzeichnet, dass** das Halbleiter-Flächensubstrat ein Siliziumwafer ist, der zu Zwecken der elektrischen und/oder thermischen Isolation oder aus Gründen optischer Transparenz den Siliziumwafer zumindest teilweise durchsetzende glasartige Materialbereiche aufweist.

## Claims

1. A method for structuring a flat substrate consisting of a glass-type material, by means of a combination of the following steps:
- providing a semiconductor flat substrate consisting of a semiconductor material,
- structuring at least one surface of said semiconductor flat substrate to obtain recesses in said surface,
- connecting said surface of said semiconductor flat substrate to said glass-type flat substrate by means of anodic bonding, with said structured surface of said semiconductor flat substrate being connected to a surface of said glass-type flat surface at least partially covering the same, and negative pressure prevails during the connection process so that said negative pressure is conserved in said recesses of said surface of said semiconductor flat substrates, between said semiconductor flat substrate and said glass-type substrate following said connection,
- tempering said connected flat substrates in such a manner that at least a part of the said glass-type material flows into said recesses of said structured surface of said semiconductor flat substrate,
- removing material at least from the resoldified glass-type flat substrate in such a manner that said glass-type flat substrate assumes a surface which is flush with said structured surface of said semiconductor flat substrate.

2. The method according to claim 1,
wherein at the surface of said semiconductor flat substrate opposite said surface connected to said glass-type flat substrate, semiconductor material is removed until at least those parts of the glass-type material which flowed into said recesses which are flush with said surface of said semiconductor flat substrate are exposed.

3. The method according to claim 1 or 2,
wherein said semiconductor flat substrate is separated from said glass-type flat substrate.

4. The method according to claim 3,
wherein said separation of said glass-type flat substrate from said semiconductor flat substrate occurs by means of etching said glass-type substrate away.

5. The method according to claim 3,
wherein said separation of said two flat substrates occurs by providing a separating layer between said two flat substrates.

6. The method according to claim 5,
wherein before connecting said two flat substrates, said separating layer is applied onto said structured surface of said semiconductor flat substrate in a structure retaining manner and is provided as a sacrificial layer which is destroyed in the course of thermal and/or chemical action and permits separation of said two substrates.

7. The method according to claim 5 or 6,
wherein a metal layer which has a melting point which lies below the melting point of said substrates is utilized as said separating layer.

8. The method according to claim 5 or 6,
wherein an oxidizable layer which changes chemically when oxygen and/or thermal energy is added is utilized as said separating layer.

9. The method according to claim 5 or 6,
wherein a carbon coating, diamond-like layer or SiC is utilized as said separating layer.

10. The method according to one of the claims 1 to 9,
wherein said glass-type material and said semiconductor material possess almost the same thermal expansion coefficients.

11. The method according to one of the claims 1 to 10,
wherein said flat substrate consisting of a glass-type material is a boron silicate glass.

12. The method according to one of the claims 1 to 11,
wherein said semiconductor flat substrate is a silicon substrate.

13. The method according to one of the claim 1 to 12,
wherein during tempering, overpressure acts on the surface of said glass-type flat substrate facing away from said semiconductor flat substrate.

14. The method according to one of the claims 1 to 13,
wherein by controlling the temperature and the duration, said tempering process is conducted in such a manner that the flowing of said glass-type material into said recesses of said semiconductor flat substrate ends when said glass-type material has filled said recesses completely.

15. The method according to one of the claims 3 to 14,
wherein after separation of said two flat substrates, said glass-type flat substrate is finished mechanically to obtain breakthroughs penetrating vertically through said flat substrate.

16. The method according to claim 15,
wherein said breakthroughs are filled with an electrically conducting material.

17. The method according to one of the claims 1 to 15,
wherein said structuring of said semiconductor flat substrate occurs by means of lithographic methods followed by an etching technique in order to produce structures with structural dimensions in the micrometer and/or sub-micrometer range.

18. The method according to claim 17,
wherein said structures in the form of recesses have an aspect ratio (height respectively depth:width) of 10:1.

19. A glass-type flat substrate produced according to one of the methods according to claims 1 to 18,
wherein said glass-type flat substrate is penetrated perpendicular to the substrate surface by breakthroughs in which electrically conducting material is provided.

20. The glass-type flat substrate according to claim 19,
wherein said breakthroughs filled with electrically conducting material are arranged in an array-like manner.

21. Use of the glass-type flat substrate according to claim 19 or 20 for electrical contacting components in microelectronics or micro-mechanics.

22. A method according to one of the claims 1 to 18 for producing a semiconductor flat substrate interspersed with said glass-type material.

23. The method according to claim 22, wherein said semiconductor flat substrate is a silicon wafer which, for the purpose of electrical and/or thermal insulation or for reasons of optical transparency, is provided with regions of glass-type material which at least partially penetrates said silicon.

## Revendications

1. Procédé de structuration d'un substrat de surface constitué d'un matériau vitreux,
au moyen de la combinaison des étapes de procédé suivantes :
- fournir un substrat de surface semi-conducteur constitué d'un matériau semi-conducteur,
- structurer au moins une surface supérieure du substrat de surface semi-conducteur afin d'obtenir des cavités sur la surface supérieure,
- lier la surface supérieure du substrat de surface semi-conducteur au substrat de surface vitreux par soudure anodique, moyennant quoi la surface supérieure structurée du substrat de surface semi-conducteur est assemblée de manière à la recouvrir au moins partiellement à une surface supérieure du substrat de surface vitreux, et pendant le processus de liaison, une dépression prédomine, de telle sorte que cette dernière soit conservée après la soudure dans les cavités de la surface supérieure du substrat de surface semi-conducteur, entre le substrat de surface semi-conducteur et le substrat de surface vitreux.
- malléabiliser les surfaces de substrat reliées de telle sorte qu'un écoulement d'au moins des portions du matériau vitreux dans les cavités de la surface supérieure structurée du substrat de surface semi-conducteur se produise,
- enlever le matériau d'au moins le substrat de surface vitreux à nouveau fixé de telle sorte que le substrat de surface vitreux adopte une surface supérieure adjacente et soudée à la surface supérieure structurée du substrat de surface semi-conducteur.

2. Procédé selon la revendication 1,
**caractérisé en ce que,** sur la surface supérieure du substrat de surface semi-conducteur, qui repose en vis à vis de la surface supérieure reliée au substrat de surface vitreux, du matériau semi-conducteur est enlevé, jusqu'à ce qu'au moins des portions du matériau vitreux coulé dans les cavités soient mises à découvert, lesquelles sont adjacentes et soudées à la surface supérieure du substrat de surface semi-conducteur.

3. Procédé selon la revendication 1 ou 2,
**caractérisé en ce que** la surface de substrat semi-conducteur est séparée du substrat de surface vitreux.

4. Procédé selon la revendication 3,
**caractérisé en ce que** la séparation du substrat de surface vitreux et du substrat de surface semi-conducteur se produit par attaque chimique du matériau semi-conducteur.

5. Procédé selon la revendication 3,
**caractérisé en ce que** les deux substrats de surface sont séparés l'un de l'autre en prévoyant une couche de séparation entre les deux substrats de surface.

6. Procédé selon la revendication 5,
**caractérisé en ce que,** avant l'assemblage des deux substrats de surface, la couche de séparation est reçue sur la surface supérieure structurée du substrat de surface semi-conducteur sans endommager la structure et est configurée comme une couche sacrifiée, qui est détruite au cours des réactions thermiques et/ou chimiques et permet une séparation des deux substrats l'un de l'autre.

7. Procédé selon la revendication 5 ou 6,
**caractérisé en ce que,** comme couche de séparation, une couche de métal est utilisée, qui présente un point de fusion en dessous du point de fusion des substrats.

8. Procédé selon la revendication 5 ou 6,
**caractérisé en ce que,** comme couche de séparation, une couche oxydante est utilisée, qui se transforme chimiquement sous l'effet de l'oxygène et/ou de l'énergie thermique.

9. Procédé selon la revendication 5 ou 6,
**caractérisé en ce que,** comme couche de séparation, une couche de carbone, une couche de diamant, une couche similaire au diamant ou de SiC est utilisée.

10. Procédé selon une des revendications 1 à 9,
**caractérisé en ce que** le matériau vitreux et le matériau semi-conducteur disposent de coefficients de dilatation thermique approximativement similaires.

11. Procédé selon une des revendications 1 à 10,
**caractérisé en ce que** le substrat de surface constitué d'un matériau vitreux est du bore-silicate-verre.

12. Procédé selon une des revendications 1 à 11,
**caractérisé en ce que** le substrat de surface semi-conducteur est un substrat de silicium.

13. Procédé selon une des revendications 1 à 12,
**caractérisé en ce que,** pendant la malléabilisation, une surpression agit sur la surface supérieure du substrat de surface vitreux, qui se détourne du substrat de surface semi-conducteur.

14. Procédé selon une des revendications 1 à 13,
**caractérisé en ce que** le processus de malléabilisation est effectué en commandant la température et la durée de telle sorte que l'écoulement du matériau vitreux dans les cavités du substrat de surface semi-conducteur soit terminé, lorsque le matériau vitreux remplit complètement les cavités.

15. Procédé selon une des revendications 3 à 14,
**caractérisé en ce que,** après la séparation des deux substrats de surface l'un de l'autre, le substrat de surface vitreux est façonné mécaniquement, afin d'obtenir des brèches traversant perpendiculairement le substrat de surface.

16. Procédé selon la revendication 15,
**caractérisé en ce que** les brèches sont remplies d'un matériau conducteur d'électricité.

17. Procédé selon une des revendications 1 à 15,
**caractérisé en ce que** la structuration du substrat de surface semi-conducteur est effectuée au moyen d'une technique de lithographie et de la technique suivante d'attaque chimique afin de produire des structures ayant des dimensions à l'échelle du micron et/ou du sous micron.

18. Procédé selon la revendication 17,
**caractérisé en ce que** les structures en forme de cavités présentent un rapport d'aspect (hauteur, respectivement profondeur :largeur) de 10 :1.

19. Substrat de surface vitreux, produit selon un procédé selon les revendications 1 à 18,
**caractérisé en ce que** le substrat de surface vitreux est traversé par des percées perpendiculaires à la surface supérieure de substrat, dans lesquelles un matériau conducteur d'électricité est prévu.

20. Substrat de surface vitreux selon la revendication 19,
**caractérisé en ce que** les percées remplies du matériau conducteur d'électricité sont disposées en forme de matrice.

21. Utilisation du substrat de surface vitreux selon la revendication 19 ou 20 pour la connexion électrique de composants en microélectronique ou en micromécanique.

22. Procédé selon une des revendications 1 à 18,
**caractérisé en ce qu'**un substrat de surface semi-conducteur traversé par un matériau vitreux est fabriqué.

23. Procédé selon la revendication 22,
**caractérisé en ce que** le substrat de surface semi-conducteur est une plaquette de silicium, qui, dans un but d'isolation électrique et/ou thermique ou pour des raisons de transparence optique, présente des portions de matériau vitreux traversant au moins partiellement la plaquette de silicium.
